## Europäisches Patentamt
## European Patent Office
## Office européen des brevets

(19)

(11) Veröffentlichungsnummer: **0 176 800**
**B1**

(12) **EUROPÄISCHE PATENTSCHRIFT**

(45) Veröffentlichungstag der Patentschrift: **30.05.90**

(21) Anmeldenummer: **85111245.8**

(22) Anmeldetag: **05.09.85**

(51) Int. Cl.⁵: **H 03 K 17/18, H 03 K 17/08**

(54) **Verfahren und Vorrichtung zur Bestimmung des Schaltzustands eines Abschaltthyristors.**

(30) Priorität: **18.09.84 DE 3434607**

(43) Veröffentlichungstag der Anmeldung:
**09.04.86 Patentblatt 86/15**

(45) Bekanntmachung des Hinweises auf die
Patenterteilung:
**30.05.90 Patentblatt 90/22**

(84) Benannte Vertragsstaaten:
**AT CH DE FR GB LI NL SE**

(56) Entgegenhaltungen:
**US-A-3 478 257**

**ELEKTROTECHNIK, Band 64, Nr. 24, 17. Dezember 1982, Seiten 16-21, Würzburg, DE; W. BÖSTERLING et al.: ''Praxis mit dem GTO. Abschaltthyristoren für selbstgeführte Stromrichter, Teil 1**
**ELEKTROTECHNIK, Band 65, Nr. 4, 28. Februar 1983, Seiten 14-17, Würzburg, DE; W. BÖSTERLING et al.: ''Praxis mit dem GTO. Abschaltthyristoren für selbstgeführte Stromrichter, Teil 2**

(73) Patentinhaber: **Siemens Aktiengesellschaft Wittelsbacherplatz 2 D-8000 München 2 (DE)**

(72) Erfinder: **Marquardt, Rainer, Dr. Eskilstunastrasse 29 D-8520 Erlangen (DE)**
Erfinder: **Salzmann, Theodor, Dipl.-Ing. Leimbergerstrasse 29 D-8520 Erlangen (DE)**
Erfinder: **Peppel, Michael, Dr. Albert-Schweitzer-Strasse 6A D-8525 Uttenreuth (DE)**

**Beschreibung**

Die Erfindung betrifft ein Verfahren zur Bestimmung des Schaltzustandes eines Abschaltthyristors (GTO-Thyristor), der in Abhängigkeit von einem Einschalt- bzw. Abschaltsignal in einen stromleitenden bzw. einen stromsperrenden Schaltzustand steuerbar ist.

Aus der US 3 478 257 ist ein Steuersystem für einen Gleichrichter bekannt, der mit konventionellen Thyristoren als steuerbare Halbleiterschaltelemente ausgerüstet ist. Ein den stromleitenden Zustand eines der Thyristoren anzeigendes Zustandssignal wird dabei durch Auswerten der zwischen der jeweiligen Thyristorsteuerelektrode und Kathodenelekrode anliegenden Spannung gebildet.

In der Zeitschrift "Elektrotechnik" Heft 4, 1983, Seite 14 bis 17 ist in Bild 12 eine Vorrichtung zum Betreiben eines Abschaltthyristors dargestellt, der in einem Brückenzweig eines Stromrichters angeordnet ist. Dem Anschaltthyristor ist ein Steuergenerator zugeordnet, der ausgangsseitig an dem Gate-Anschluß und dem kathodenanschluß des Anschaltthyristors liegt und diesen in Abhängigkeit von einem Einschaltbefehl oder Abschaltbefehl in einen stromleitenden bzw. stromsperrenden Zustand steuert; das Prinzipschaltbild eines derartigen Steuergenerators ist in der Zeitschrift "Elektrotechnik", Heft 24, 1982, Seiten 16 bis 21 in Bild 7 dargestellt. Um einen zuverlässigen Betrieb des Abschaltthyristors zu gewährleisten, müssen Strom und Spannung an dem Abschaltthyristor in vorgegebenen Grenzen bleiben. Hierzu ist bei der bekannten Vorrichtung eine parallel zu dem Abschaltthyristor liegende Anordnung mit einem Kondensator, einem Widerstand und zwei Dioden vorgesehen; weiterhin ist in Reihe mit dem Abschaltthyristor eine Induktivität angeordnet und eine Stromsensoreinrichtung vorgesehen, die den Strom durch den Abschaltthyristor erfaßt und im Überstromfall einen Abschaltbefehl an den Steuergenerator abgibt.

Bei der bekannten Vorrichtung ist es erforderlich, daß die oben bezeichneten Schaltungsmaßnahmen zur Begrenzung des Strom- und Spannungsverlaufes an dem Abschaltthyristor für den ungünstigsten Betriebsfall des Abschaltthyristors in dem Stromrichter ausgelegt sein müssen, um ständig einen sicheren Betrieb des Abschaltthyristors zu gewährleisten; jedoch stehen diese Schaltungsmaßnahmen der Forderung nach einem schnellen Ein- und Abschalten des Stromes durch den Abschaltthyristor entgegen. So ist beispielsweise die in Reihe mit dem Abschaltthyristor liegende Induktivität derart bemessen, daß sie im Überstromfall den Anstieg des Stromes durch den Abschaltthyristor soweit begrenzt, daß ein Abschalten des Abschaltthyristors durch die Stromsensoreinrichtung möglich ist, bevor der Strom einen maximalen zulässigen abschaltbaren Durchlaßstromwert des Abschaltthyristors erreicht. Die Anordnung der Induktivität ist mit einem relativ großen zusätzlichen schaltungstechnischen Aufwand verbunden und hat darüber hinaus zusätzliche Verluste und Spannungsabfälle zur Folge.

Um einen Kurzschluß in dem Stromrichter zu vermeiden, ist nach der Abgabe eines Abschaltsignales an den den Abschaltthyristor steuernden Steuergenerator eine Ansteuerung des in demselben Brückenzweig angeordneten weiteren Abschaltthyristors in einen stromleitenden Zustand erst dann möglich, wenn der Abschaltthyristor in einen stromsperrenden Zustand übergegangen ist. Es ist daher erforderlich, für einen zuverlässigen Betrieb des Abschaltthyristors in Abhängigkeit von den Schaltungsmaßnahmen an dem Abschaltthyristor und seiner Ansprechverzögerung eine für den ungünstigsten Betriebsfall bemessene Verriegelungszeit nach dem Auftreten des Abschaltsignales festzulegen, während derer eine Ansteuerung des weiteren Abschaltthyristors in den stromleitenden Zustand nicht möglich ist. Die Einhaltung der Verriegelungszeit hat jedoch ein ungünstiges Betriebsverhalten des Stromrichters zur Folge.

Der Erfindung liegt daher die Aufgabe zugrunde, einen besoners zuverlässigen und hinsichtlich der Ausnutzung und des Schutzes des Abschaltthyristors optimalen Betrieb des Abschaltthyristors zu ermöglichen.

Zur Lösung dieser Aufgabe wird gemäß der Erfindung der in den Gate-Anschluß des Abschaltthyristors fließende Gate-Strom erfaßt und nach dem Auftreten eines Abschaltsignales ein Hilfssignal gebildet, welches der zeitlichen Änderung des Gate-Stromes entspricht; bei einem Vorzeichenwechsel des Hilfssignales wird ein Zustandssignal erzugt, welches den Übergang des Abschaltthyristors in den stromsperrenden Schaltzustand anzeigt.

Bei dem erfindungsgemäßen Verfahren nach Anspruch 1 findet in vorteilhafter Weise eine Funktionsüberwachung des Abschaltthyristors statt, indem aus dem Verlauf des Gate-Stromes der momentane Schaltzustand des Abschaltthyristors angeleitet wird und zur Erzeugung eines Zustandssignales herangezogen wird. Dabei entspricht die Zeitdauer vom Auftreten des Abschaltbefehles bis zur Erzeugung des Zustandssignales etwa der Speicherzeit des Abschaltthyristors, die eine von der Temperatur, den Ansteuerbedingungen und dem Durchlaßstrom des Abschaltthyristors abhängige Abschaltverzögerungszeit darstellt. Nach dem Ablauf der Speicherzeit, also etwa zum Zeitpunkt des Auftretens des Zustandssignals, wird der Strom durch den Abschaltthyristor abgeschaltet und der Abschaltthyristor befindet sich dann im stromsperrenden Schaltzustand. Aufgrund des abgegebenen Zustandssignales können in vorteilhafter Weise Fehlerfälle schnell erkannt und Maßnahmen zum Schutz des Abschaltthyristors bzw. eines Gerätes, in dem der Abschaltthyristor angeordnet ist, eingeleitet werden. Weiterhin wird durch die Abgabe des Zustandssignales eine adaptive Steuerung des Abschaltthyristors bzw. des Gerätes oder Schaltungsteile von diesem in Abhängigkeit von dem momentanen Schaltzustand des Abschaltthyristors ermöglicht, so daß die Steuerung im Hinblick auf einen optimalen Betrieb des Abschaltthyristors oder Gerätes schnellstmöglich ohne Einhaltung erwaiger fester und unnötig großer Verriegelungszeiten erfolgen kann.

Eine weitere Vorteilhafte Ausführungsform der Erfindung besteht darin, daß der erfaßte Gate-Strom auf Unterschreiten eines negativen Schwellenstromwertes überwacht wird und ein den Übergang des Abschaltthyristors in den stromsperrenden Schaltzustand anzeigendes Zustandssignal erst erzeugt wird, wenn auch der negative Schwellenstromwert unterschritten ist. Bei einer weiteren Ausführungsform der Erfindung wird ein den stromsperrenden Schaltzustand anzeigendes Zustandssignal auch dann erzeugt, wenn innerhalb einer vorgegebenen Zeitdauer nach dem Auftreten des Abschaltbefehles der negative Schwellenstromwert nicht unterschritten worden ist. Auf diese Weise wird erreicht, daß auch dann das Zustandssignal erzeugt wird, wenn sich der Abschaltthyristor zum Zeitpunkt seines Abschaltens im Leerlaufbetrieb befindet oder wenn ein sehr kleiner Strom durch den Abschaltthyristor abgeschaltet wurde und dieser daher bereits bei einem sehr geringen, unter dem negative Schwellenstromwert liegenden negativen Gate-Strom seinen stromsperrenden Schaltzustand erreicht hat. In diesem Fall wird das Zustandssignal nach Ablauf der vorgegebenen Zeitdauer vom Auftreten des Abschaltsignales an erzeugt. Weiterhin wird auf diese Weise verhindert, daß zu Beginn des negativen Gate-Stroms etwa von dem Zeitpunkt des Auftretens des Abschaltsignales an bis zum Unterschreiten des negativen Schwellenstromwertes durch den Gate-Strom eine fehlerhafte Erfassung des Gate-Stromes zur Abgabe eines den stromsperrenden Zustand anzeigenden Signales führt.

Von besonderem Vorteil ist es, wenn gleichzeitig mit dem Auftreten des Abschaltsignales ein Zeitablauf mit einer vorgegebenen Ablaufzeit veranlaßt und ein Fehlermeldesignal erzeugt wird, wenn der Zeitablauf vor dem Auftreten des Zustandssignales beendet ist. Dadurch wird auf besonders einfache Weise eine Überwachung des Abschaltthyristors im Hinblick auf eine mögliche Überlastung erreicht, indem die physikalische Eigenschaft des Abschaltthyristors, daß seine Speicherzeit mit steigendem Durchlaßstrom und steigender Sperrschichttemperatur zunimmt, ausgenutzt wird, um ein Fehlermeldesignal zu erzeugen, sobald die Speicherzeit einen der vorgegebenen Ablaufzeit entsprechenden Maximalwert überschreitet. Dabei kommt dem Fehlermeldesignal eine besondere Bedeutung zur Anzeige eines Überstromes durch den Abschaltthyristor zu, weil, wie eingangs bereits erläutert, ein maximaler abschaltbarer Durchlaßstromwert für den Abschaltthyristor existiert, oberhalb dessen ein Abschaltversuch zur Zerstörung des Abschaltthyristors führen kann. Die vorgegebene Ablaufzeit ist daher so gewählt, daß sie kürzer als die Speicherzeit des Thyristors im Überstromfall ist; ein unzulässiger Abschaltversuch wird durch Überschreiten der vorgegebenen Ablaufzeit erkannt und abgebrochen, indem beim Auftreten des Fehlermeldesignales der Abschaltthyristor durch eine Schutzzündung in einen stromleitenden Zustand gesteuert wird. Im Unterschied zu der eingangs angegebenen bekannten Vorrichtung wird bei dem erfindungsgemäßen Verfahren zur Überstromüberwachung des Abschaltthyristors keine zusätzliche Stromsensoreinrichtung und keine zusätzliche, den Stromanstieg begrenzende Induktivität benötigt. Außerdem wird bei dem erfindungsgemäßen Verfahren ein Ansprechen der Überstromüberwachung bei kurzzeitigen Spitzenströmen während des stromleitenden Schaltzustandes des Abschaltthyristors verhindert, da derartige Spitzenströme zulässige Werte aufweisen dürfen, die größer als der maximale abschaltbare Durchlaßstromwert sind.

Die Überwachung des Abschaltthyristors hinsichtlich einer möglichen Überlastung läßt sich in vorteilhafter Weise dadurch erweitern, daß vom Auftreten des Abschaltsignales an bis zur Erzeugung des Zustandssignals aus dem erfaßten Gate-Strom eine Integrationsgröße abgeleitet wird, die dem zeitlichen Integral des Gate-Stromes entspricht, und daß ein Überlastungsmeldesignal erzeugt wird, wenn die Integrationsgröße vor dem Auftreten des Zustandssignales einen vorgegebenen Schwellenwert überschreitet. Dabei entspricht die Integrationsgröße beim störungsfreien Abschalten zum Zeitpunkt des Auftretens des Zustandssignales der Abschaltladung der Abschaltthyristors. Überschreitet der abzuschaltende Durchlaßstrom durch den Abschaltthyristor den maximal zulässigen abschaltbaren Durchlaßstromwert, su übersteigt die Abschaltladung den vorgegebenen Schwellenwert, woraufhin das Überlastungsmeldesignal erzeugt wird. Auch in diesem Fall wird der Abschaltversuch beim Auftreten des Überlastungsmeldesignals vorteilhafterweise durch Schutzzünden des Abschaltthyristors in den stromleitenden Zustand abgebrochen.

Da die Abschaltladung des Abschaltthyristors im Vergleich zu seiner Speicherzeit einerseits eine wesentlich geringere Abhängigkeit von der Ansteuerbedingungen und des Durchlaßstromes des Abschaltthyristors aufweist und andererseits temperaturabhängiger ist, besteht die Möglichkeit, im Fehlerfall nachträglich anhand des Fehlermeldesignales und des Überlastungsmeldesignales festzustellen, ob die Überlastung durch unzureichende Ansteuerbedingungen wie z.B. einen zu geringen negativen Gate-Strom, oder durch eine zu hohe Sperrschichttemperatur des Abschaltthyristors hervorgerufen worden ist.

Wie oben angegeben, ermöglicht die Erzeugung des Zustandssignales eine adaptive Steuerung des Abschaltthyristors oder eines Gerätes, in dem dieser enthalten ist. Von besonderem Vorteil ist dabei die Anwendung des angegebenen erfindungsgemäßen Verfahren bei jedem von zwei Abschaltthyristoren, von denen der erste Abschaltthyristor in einer Brückenzweighälfte und der zweite Abschaltthyristor in der anderen Brückenzweighälfte eines Stromrichters liegt, indem das Einschaltsignal dem ersten Abschaltthyristor nur beim Vorhandensein des den stromsperrenden Schaltzustand des zweiten Abschaltthyristors anzeigenden Zustandssignals zugeführt wird und das Einschaltsignal dem zweiten Abschaltthyristor nur beim Vorhandensein des den stromsperrenden Schaltzustand des ersten Abschaltthyristors anzeigenden Zustandssignals zugeführt wird. Damit wird eine gegenseitige adaptive Verriegelung der Abschaltthyristoren in den beiden Brückenzweighälften des Stromrichters erreicht, die es ermöglicht, den Stromrichter statt mit einer fest vorgegebenen, dem ungünstigsten Betriebsfall angepaßten Verriegelungszeit mit der aufgrund des physikalischen Verhaltens der Abschaltthyristoren kürzestmöglichen Verriegelungszeit zu betreiben, ohne daß die Gefahr eines Kommutierungskurzschlusses durch einen leitenden Schaltzustand beider Abschaltthyristor besteht.

Bei einer Vorrichtung zur Bestimmung des Schaltzustandes eines Abschaltthyristors, der mit seinem Gate-Anschluß und seinem Kathodenanschluß an einem Abschaltstromkreis angeschlossen ist, ist gemäß der Erfindung nach Anspruch 9 eine Stromerfassungseinrichtung mit ihrem strommempfindlichen Eingang in den Abschaltstromkreis angeordnet; an dem Ausgang der Stromerfassungseinrichtung ist ein Differenzierglied angeschlossen und dem Differenzierglied ist ein Vorzeichendetektor nachgeordnet, dessen Ausgang zur Abgabe eines Zustandssignales mit einem Zustandssignalausgang der Vorrichtung in Verbindung steht. Dabei wird entsprechend dem erfindungsgemäßen Verfahren nach Anspruch 1 der zum Abschalten des Abschaltthyristors seinem Gate-Anschluß zugeführte negative Gate-Strom von der Stromerfasssungseinrichtung erfaßt; das nachgeordnete Differenzierglied erzeugt ein der zeitlichen Änderung des negativen Gate-Stromes entsprechendes Hilfssignal, bei dessen Vorzeichenumkehr der Vorzeichendetektor den Zustandssignalausgang der Vorrichtung zur Abgabe des Zustandssignales aktiviert.

Der stromempfindliche Eingang der Stromerfassungseinrichtung kann beispielsweise aus einem in dem Abschaltstromkreis in Reihe mit einer steuerbaren Schalteinrichtung angeordneten Stromerfassungswiderstand bestehen, dem eine Spannungserfassungseinrichtung zur Erfassung des stromproportionalen Spannungsabfalles an dem Stromerfassungswiderstand zugeordnet ist. Besonders vorteilhaft ist jedoch eine Ausbildung der weiteren erfindungsgemäßen Vorrichtung, bei der die steuerbare Schalteinrichtung ein Feldeffekttransistor ist, wobei der Drain-Anschluß und der Source-Anschluß des Feldektransistors den empfindlichen Eingang der Stromerfassungseinrichtung bilden, an dem eine Spannungserfassungseinrichtung zur Erfassung des Spannungsabfalls an dem Feldeffekttransistor liegt, weil dabei eine schaltungstechnische Veränderung des Abschaltstromkreises beispielsweise durch Einfügung eines Stromerfassungswiderstandes nicht erforderlich ist. Dabei wird in vorteilhafter Weise das nahezu omhsche Verhalten des Feldeffekttransistors im durchgeschalteten Zustand ausgenutzt, weil der Spannungsabfall an dem zum Abschalten des Abschaltthyristors in einen stromleitenden Schaltzustand gesteuerten Feldeffekttransistor proportional zu dem negativen Gate-Strom ist.

Eine Weiterbildung der erfindungsgemäßen Vorrichtung enthält einen Schwellenwertkomparator, der an dem Ausgang der Stromerfassungseinrichtung liegt, eine Zeitgeberstufe, die bei Beaufschlagung mit dem Abschaltsignal an einem Ausgang ein Impulssignal mit einer vorgegebenen Zeitdauer abgibt, und eine steuerbare Speichereinrichtung, die mit einem ersten Steuereingang an dem Ausgang der Zeitgeberstufe angeschlossen ist, mit einem zweiten Steuereingang an dem Ausgang des Schwellenwertkomparators liegt, über einen dritten Steuereingang an dem Ausgang des Vorzeichendetektors angeschlossen ist und ausgangsseitig mit dem Zustandssignalausgang zur Agabe des Zustandssignals in Verbindung steht, wobei die steuerbare Speichereinrichtung während der Ansteuerung ihres ersten Steuereingangs durch Ansteuerung des zweiten Steuereingangs von einem ersten Zustand, in dem die steuerbare Speichereinrichtung bei Beendigung der Ansteuerung ihres ersten Steuereingangs das Zustandssignal abgibt, in einen zweiten Zustand umsteuerbar ist, in dem die steuerbare Speichereinrichtung bei Ansteuerung des dritten Steuereingangs ein Zustandssignal abgibt. Dadurch wird in vorteilhafter Weise eine sichere Erfassung des Überganges des Abschaltthyristors in den stromsperrenden Schaltzustand erreicht, in dem die Erzeugung des den stromsperrenden Schaltzustand anzeigenden Zustandssignales so lange verhindert wird, bis der negative Gate-Strom den vorgegebenen Schwellenstromwert unterschreitet. Dies is insbesondere dann von Bedeutung, wenn die Erfassung des negativen Gate-Stromes durch den Spannungsabfall an dem Feldeffekttransistor erfolgt, weil unmittelbar nach dem Auftreten des Abschaltbefehles durch den Übergang des Feldeffekttransistors von dem stromsperrenden in den stromleitenden Zustand Fehler bei der Erfassung des negativen Gatestromes auftreten können, die fälschlicherweise zu einer Abgabe des Zustandssignales führen können. Ein weiterer Vorteil dieser Weiterbildung der erfindungsgemäßen Vorrichtung besteht darin, daß das Zustandssignal ersatzweise erzeugt wird, wenn aufgrund eines sehr geringen, den Schwellenstromwert nicht unterschreitenden negativen Gate-Stromes davon ausgegangen werden kann, daß ein Leerlaufbetrieb des Abschaltthyristors vorliegt oder daß ein nur sehr geringer Strom abgeschaltet worden ist.

Hinsichtlich der Ausführung der steuerbaren Speichereinrichtung bestehen mehrere Möglichkeiten. Ein schaltungstechnisch besonders einfa-

cher Aufbau der erfindungsgemäßen Vorrichtung wird in vorteilhafter Weise dadurch erreicht, daß die steuerbare Speichereinrichtung ein Delay-Flipflop enthält, dessen Dateneingang den ersten Steuereingang bildet, dessen Takteingang den zweiten Steuereingang bildet und dessen Rücksetzeingang der dritte Steuereingang ist, daß die Zeitgeberstufe bei Beaufschlagung mit dem Abschaltsignal an einem weiteren Ausgang ein Verzögerungssignal mit einer der vorgegebenen Zeitdauer entsprechenden Verzögerung abgibt und daß der weitere Ausgang der Zeigeberstufe und der invertierende Ausgang des Delay-Flipflops über ein UND-Glied mit dem Zustandssignalausgang verbunden sind.

Um eine Überwachung des Abschaltthyristors hinsichtlich einer Überlastung entsprechend dem Verfahren nach Anspruch 6 zu ermöglichen, liegt bei einer vorteilhaften Weiterbildung der erfindungsgemäßen Vorrichtung an dem Ausgang der Stromerfassungseinrichtung eine Integriereinrichtung, die einen Unterbrechungseingang aufweist, der mit dem Zustandssignalausgang in Verbindung steht; der Intgegriereinrichtung ist ein Schwellenwertdetektor nachgeschaltet, der ausgangsseitig zur Abgabe eines Überlastungsmeldesignales mit einem Überlastungsmeldeausgang der Vorrichtung in Verbindung steht.

Eine weitere Ausbildung der erfindungsgemäßen Vorrichtung enthält eine Zeitablaufvorrichtung zur Erzeugung eines Zeitablaufs mit einem Starteingang, der mit dem Abschaltsignal beaufschlagt ist, mit einem Unterbrechungseingang, der mit dem Zustandssignalausgang in Verbindung steht, und mit einem Fehlermeldeausgang zur Abgabe eines Fehlermeldesignales bei Beendigung des Zeitablaufes. Dadurch wird eine Überwachung des Abschaltthyristors bezüglich einer Überlastung entsprechend dem in Anspruch 4 angegebenen Verfahren ermöglicht.

Bei einer wegen der Verwendung digitaler Schaltungsbauelemente besonders einfachen Ausbildung der erfindungsgemäßen Vorrichtung enthält die Zeitablaufvorrichtung ein Monoflop, dessen Triggereingang den Starteingang der Zeitablaufvorrichtung bildet; der Ausgang des Monoflops ist mit dem Takteingang eines Delay-Flipflops verbunden, dessen Dateneingang den Unterbrechungseingang bildet und dessen Ausgang den Fehlermeldeausgang der Zeitablaufvorrichtung bildet.

Zur Ansteuerung des Abschaltthyristors in einen stromleitenden Schaltzustand ist der Abschaltthyristor im allgemeinen mit seinem Gate-Anschluß und seinem Kathodenanschluß in einem Einschaltstromkreis angeordnet, wobei dem Gate-Anschluß über einen steuerbaren Schalter aus einem auf positivem Spannungspotential liegenden Spannungsanschluß ein positiver Gate-Strom zuführbar ist. Um eine Schutzzündung des Abschaltthyristors entsprechend dem Verfahren nach Anspruch 5 zu ermöglichen, kann der steuerbare Schalter mit dem Fehlermeldeausgang verbunden sein. Von besonderem Vorteil ist es aber, wenn der Gate-Anschluß des Abschaltthyristors über eine zusätzliche steuerbare Schalteinrichtung an einem positiven Hilfsspannungsanschluß angeschlossen ist und der Steuereingang der zusätzlichen steuerbaren schalteinrichtung mit dem Fehlermeldeausgang verbunden ist. Indem nämlich der positive Hilfsspannungsanschluß mit einem höheren positiven Spannungspotential als beispielsweise der Spannungsanschluß des Einschaltstromkreises beaufschlagt ist, wird im Falle der Schutzzündung des Abschaltthyristors diesem ein Zündimpuls mit besonders großer Amplitude und Steilheit zugeführt, so daß eine sehr schnelle und sichere Schutzzündung gewährleistet ist. Aus diesem Grund besteht die zusätzliche steuerbare Schalteinrichtung vorzugsweise aus einem Hilfsthyristor.

Eine ebenso sicher Schutzzündung des Abschaltthyristors gemäß dem Verfahren nach Anspruch 7 wird in vorteilhafter Weise dadurch erreicht, daß der Überlastungsmeldeausgang mit dem Steuereingang der zusätzlichen steuerbaren Schalteinrichtung verbunden ist.

Zur Erläuterung der Erfindung sind in der Zeichnung mehrere Ausführungsbeispiele der erfindungsgemäßen Vorrichtung dargestellt; dabei zeigt

Fig. 1 ein Diagramm mit Strom- und Spannungsverläufen an dem Abschaltthyristor,

Fig. 2 ein Blockschaltbild eines weiteren bevorzugten Ausführungsbeispiels der erfindungsgemäßen Vorrichtung,

Fig. 3 und Fig. 4 jeweils ein Diagramm mit in Fig. 2 bezeichneten Strom- und Spannungsverläufen und

Fig. 5 eine Anordnung der erfindungsgemäßen Vorrichtung in einem Stromrichter.

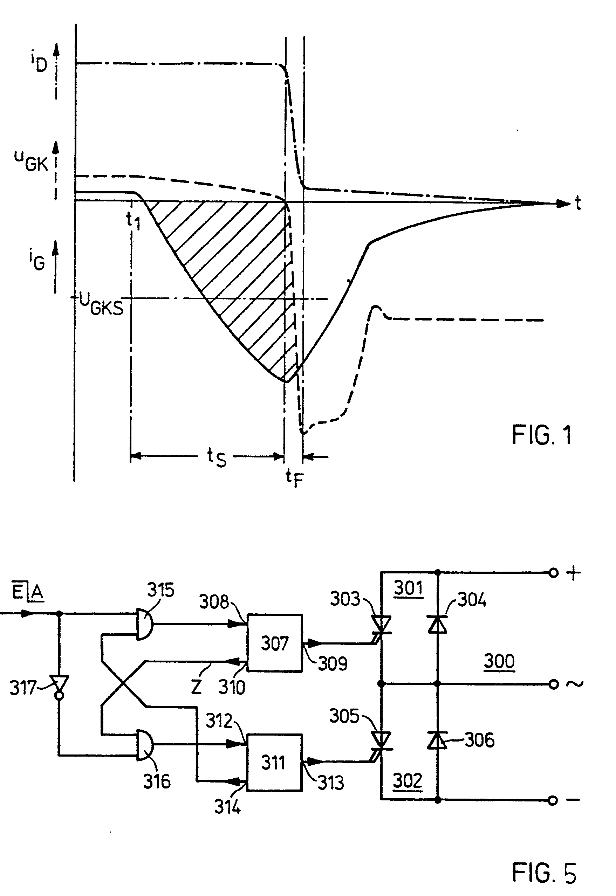

Im folgenden sollen zunächst die Strom- und Spannungsverhältnisse an einem Abschaltthyristor während eines Abschaltvorganges erläutert werden. Dazu ist in Figur 1 der zeitliche Verlauf des Durchlaßstromes $i_D$ durch den Abschaltthyristor, der Gate-Strom $i_G$ in den Gate-Anschluß des Abschaltthyristors und die Spannung $u_{GK}$ zwischen dem Gate-Anschluß und dem Kathodenanschluß des Abschaltthyristors bei dessen Abschaltung dargestellt. Bis zum Zeitpunkt $t_1$ befindet sich der Abschaltthyristor in einem stromleitenden Schaltzustand und es fließt ein konstanter Durchlaßstrom $i_D$; zur Verringerung der Durchlaßverluste weisen die Spannung $u_{GK}$ und der Gate-Strom $i_G$ jeweils einen geringen positiven Wert auf. Zum Zeitpunkt $t_1$ wird aufgrund eines Abschaltbefehls durch Umkehrung der Stromrichtung des Gate-Stromes $i_G$ eine Abschaltung des Abschaltthyristors eingeleitet. Nach etwa einer Zeitdauer $t_S$, die der Speicherzeit des Abschaltthyristors entspricht, erreicht der Gate-Strome $i_G$ seinen minimalen, negativen Wert und die Spannung $u_{GK}$ zwischen dem Gate-Anschluß und dem Kathodenanschluß fällt auf einen negativen wert ab. Gleichzeitig fällt der Durchlaßstrom $i_D$ durch den Abschaltthyristor innerhalb einer kurzen Fallzeit $t_F$ auf einen geringen Restwert ab. Nach Ablauf der Fallzeit $t_F$

befindet sich der Abschaltthyristor in einem stromsperrenden Schaltzustand. Gemäß den erfindungsgemäßen Verfahren wird der Übergang des Abschaltthyristors in den stromsperrenden Schaltzustand dadurch erkannt, daß die Spannung $u_{GK}$ einen negativen Schwellenspannungswert $U_{GKS}$ unterschreitet, oder daß sich das Vorzeichen der zeitlichen Änderung des negativen Gate-Stromes $i_G$ umkehrt. Während der Gate-Strom $i_G$ von seinem minimalen, negativen Wert auf den Wert Null zurückgeht, verringert sich auch der Durchlaßstrom $i_D$ von dem Restwert auf den Wert Null. Das Integral über den negativen Gate-Strom $i_G$ von dem Zeitpunkt $t_1$ des Auftretens des Abschaltbefehls bis zum Ablauf der Fallzeit $t_F$ entspricht der Abschaltladung des Abschaltthyristors und ist durch die schraffierte Fläche gekennzeichnet.

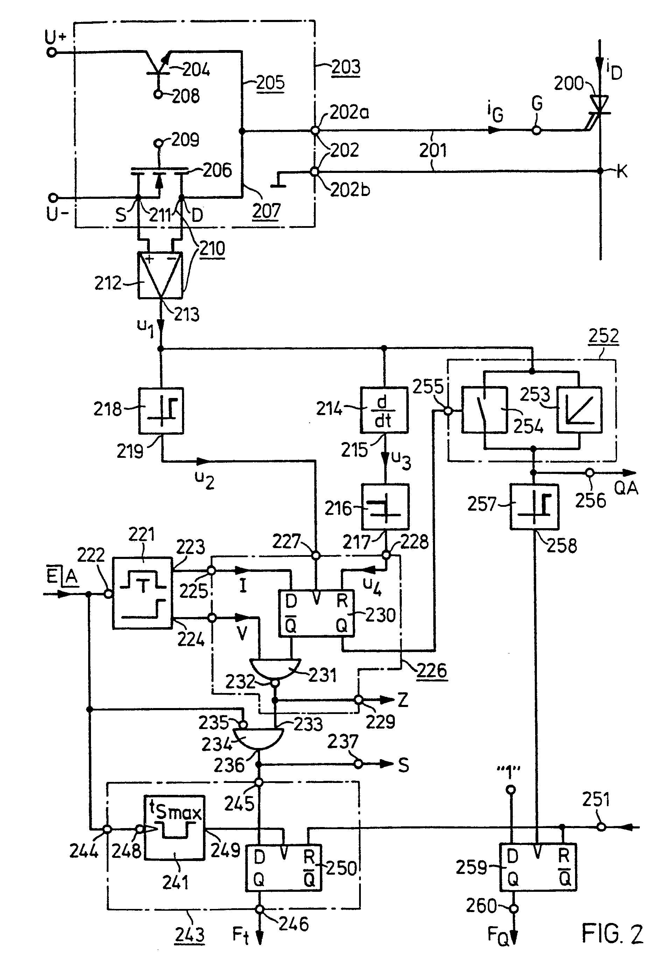

Figur 2 zeigt ein bevorzugtes Ausführungsbeispiel der erfindungsgemäßen Vorrichtung mit einem Abschaltthyristor 200, der zum Ein- und Abschalten eines Durchlaßstromes $i_D$ mit seinem Gate-Anschluß G und seinem Kathodenanschluß K über eine zweiadrige Steuerleitung 201 an dem Steuerausgang 202 eines Steuergenerators 203 angeschlossen ist. Dieser enthält wiederum eine erste steuerbare Schalteinrichtung 204, die aus einem Transistor besteht, der mit seiner Kollektor-Emitter-Strecke in einem Einschaltstromkreis 205 zwischen einem auf positiven Spannungspotential liegenden Anschluß U+ einer hier nicht dargestellten Spannungsversorgungseinrichtung und dem mit dem Gate-Anschluß G verbundenen Anschluß 202a des Steuerausganges 202 angeordnet ist. Eine zweite steuerbare Schalteinrichtung 206, bestehend aus einem Feldeffekttransistor liegt in einem Abschaltstromkreis 207 zwischen auf negativen Spannungspotential liegenden Anschluß U− der Spannungsversorgungseinrichtung und dem Anschluß 202a des Steuerausganges 202. Der mit dem Kathodenanschluß K des Abschaltthyristors 200 in Verbindung stehende Anschluß 202b des Steuerausganges 202 ist mit einem gegenüber den Anschlüssen U+ und U− auf Nullpotential liegenden Masseanschluß verbunden. Die beiden steuerbaren Schalteinrichtungen 204 und 206 sind mit ihren Steuereingängen 208 bzw. 209 an einer nicht dargestellten Steuereinrichtung zur Steuerung des Abschaltthyristors 200 in Abhängigkeit von einem Einschaltbefehl E bzw. einem Abschaltbefehl A angeschlossen.

In dem Abschaltstromkreis 207 ist eine Stromerfassungseinrichtung 210 mit ihrem stromempfindlichen Eingang 211 angeordnet. Bei dem dargestellten Ausführungsbeispiel ist der die weitere steuerbare Schalteinrichtung 206 bildende Feldeffekttransistor Bestandteil der Stromerfassungseinrichtung 210, wobei der Drain-Anschluß D und der Source-Anschluß S des Feldeffekttransistors den stromempfindlichen Eingang 211 der Stromerfassungseinrichtung 210 bildet. Diese enthält weiterhin eine Spannungserfassungseinrichtung 212, die eine hiernicht näher dargestellte Spannungsverstärkerstufe bildet und die eingangsseitig an dem stromempfindlichen Eingang 211 zur Erfassung des Spannungsabfalles an dem Feldeffekttransistor liegt.

An dem Ausgang 213 der Stromerfassungseinrichtung 210 ist ein Differenzierglied 214 angeschlossen, das im einfachsten Fall aus einem RC-Hochpaß besteht. An dem Ausgang 215 des Differenzierngliedes 214 liegt ein Vorzeichendetektor 216 mit einem Ausgang 217. An dem Ausgang 213 der Stromerfassungseinrichtung 210 liegt weiterhin ein Schwellenwertkomparator 218, der einen Ausgang 219 aufweist.

Das Ausführungsbeispiel der erfindungsgemäßen Vorrichtung enthält eine Zeitgeberstufe 221, die bei Ansteuerung ihres Einganges 222 an einem Ausgang 223 ein Impulssignal I mit einer vorgegebenen Zeitdauer T abgibt und an einem weiteren Ausgang 224 ein Verzögerungssignal V mit einer der Zeitdauer T entsprechenden Verzögerung erzeugt. Die Zeitgeberstufe 221 enthält dazu eine hier nicht gezeigte monostabile Kippstufe (Monoflop). Der Eingang 222 der Zeitgeberstufe 221 ist mit dem Einschaltbefehl E bzw. Abschaltbefehl A aus der nicht dargestellten Steuereinrichtung zur Steuerung des Abschaltthyristors 200 beaufschlagt, wobei der Einschaltbefehl E einem hochpegeligen Spannungszustand und der Ausschaltbefehl A einem Spannungszustand mit niedrigen Pegel am Eingang 222 der Zeitgebervorrichtung 221 entspricht.

Die Zeitgeberstufe 221 ist negativ-flankengesteuert, so daß eine Ansteuerung der Zeitgeberstufe 221 beim Übergang von dem hochpegeligen Einschaltbefehl E zu dem niedrigpegeligen Abschaltbefehl A erfolgt. Der Ausgang 223 der Zeitgeberstufe 221 ist mit einem ersten Steuereingang 225 einer steuerbaren Speichereinrichtung 226 verbunden; ein zweiter Steuereingang 227 ist an dem Ausgang 219 des Schwellenwertkomparators 218 angeschlossen und ein dritter Steuereingang 228 der steuerbaren Speichereinrichtung 226 ist mit dem Ausgang 217 des Vorzeichendetektor 216 verbunden. Die steuerbare Speichereinrichtung 226 ist ausgangsseitig mit einem Zustandssignalausgang 229 der erfindungsgemäßen Vorrichtung zur Abgabe eines Zustandssignales Z verbunden. In der steuerbaren Speichereinrichtung 226 ist ein Delay-Flipflop 230 angeordnet, dessen Dateneingang D den ersten Steuereingang 225 bildet, dessen Takteingang den zweiten Steuereingang 227 bildet und dessen Rücksetzeingang R der dritte Steuereingang 228 der Speichereinrichtung 226 ist. Dem weiteren Ausgang 224 der Zeitgeberstufe 221 sowie dem invertierenden Ausgang $\bar{Q}$ des Delay-Flipflops 230 ist ein NAND-Glied 231 nachgeordnet, dessen Ausgang 232 mit dem Zustandssignalausgang 229 der erfindungsgemäßen Vorrichtung verbunden ist.

Der Ausgang 232 des NAND-Gliedes 231 ist an einem nichtinvertierenden Eingang 233 eines UND-Gliedes 234 angeschlossen, das weiterhin einen mit dem Einschaltbefehl E bzw. dem Abschaltbefehl A beaufschlagten invertierenden Eingang 235 aadweist. Der Ausgang 236 des UND-Gliedes 234 ist mit einem Rückmeldeausgang 237 der erfindungsgemäßen Vorrichtung zur Abgabe eines Rückmeldesignales S mit einer der Speicherzeit $t_s$ des Abschaltthyristors 200 entsprechenden Impulslänge verbunden.

Die Erfindungsgemäße Vorrichtung nach Figur 2 enthält weiterhin eine Zeitablaufvorrichtung 243 zur Erzeugung eines Zeitablaufes mit einem Starteingang 244, der mit dem Einschaltbefehl E bzw. Abschaltbefehl A beaufschlagt ist, mit einem Unterbrechungseingang 245, der mit dem Ausgang 236 des UND-Gliedes 234 verbunden ist und mit einem Fehlermeldeausgang 246 zur Abgabe eines Fehlermeldesignales $F_t$ bei Beendigung des Zeitablaufes. Die Zeitablaufvorrichtung 243 enthält einen Monoflop 241, das bei Ansteuerung seines Triggereinganges 248 an seinem Ausgang 249 ein Impulssignal mit einer Impulsdauer abgibt, die einer vorgegebenen Ablaufzeit $t_{Smax}$ der Zeitablaufvorrichtung 243 entspricht. Der Triggereingang 248 des Monoflops 241 bildet den Starteingang 244 der Zeitablaufvorrichtung 243, wobei das Monoflop 241 negativ-flankengesteuert ist, so daß der Zeitablauf beim Übergang von dem hochpegeligen Einschaltbefehl E zu dem niedrigpegeligen Abschaltbefehl A gestartet wird. Der Ausgang 249 des Monoflops 241 ist mit dem Takteingang eines weiteren Delay-Flipflops 250 verbunden, dessen Dateneingang D den Unterbrechungseingang 245 der Zeitablaufvorrichtung 243 bildet und dessen nichtinvertierender Ausgang Q den Fehlermeldeausgang 246 bildet. Der Rücksetzeingang R des Delay-Flipflops 250 ist mit einem Rücksetzeingang 251 der erfindungsgemäßen Schaltungsanordnung verbunden.

An dem Ausgang 213 der Stromerfassungseinrichtung 210 liegt weiterhin eine Integriereinrichtung 252, die aus einem Integrierglied 253 und einem parallel dazu angeordneten steuerbaren Schaltglied 254 besteht. Der Steuereingang des steuerbaren Schaltgliedes 254 bildet einen Unterbrechungseingang 255 der Integriereinrichtung 252 und ist mit dem nichtinvertierenden Ausgang Q des Delay-Flipflops 230 verbunden. Die Integriereinrichtung 252 ist ausgangsseitig mit einem weiteren Rückmeldeausgang 256 der erfindungsgemäßen Vorrichtung zur Abgabe eines der Abschaltladung des Abschaltthyristors 200 proportionalen weiteren Rückmeldesignales $Q_A$ verbunden. Der Integriereinrichtung 252 ist ein Schwellenwertdetektor 257 nachgeordnet, dessen Ausgang 258 mit dem Takteingang eines zusätzlichen Delay-Flipflops 259 verbunden ist. Der Dateneingang D des zusätzlichen Delay-Flipflops 259 ist mit einem hochpegeligen Spannungszustand entsprechend einem logischen Zustand "1" beaufschlagt; der nichtinvertierenden Ausgang Q des zusätzlichen Delay-Flipflops 259 ist mit einem Überlastungsmeldeausgang 260 der erfindungsgemäßen Vorrichtung zur Abgabe eines weiteren Überlastungsmeldesignales $F_Q$ bei Überschreitung einer maximal zulässigen Abschaltladung des Abschaltthyristors 200 verbunden. Der Rücksetzeingang R des zusätzlichen Delay-Flipflops 259 ist mit dem Rücksetzeingang 251 der erfindungsgemäßen Vorrichtung verbunden.

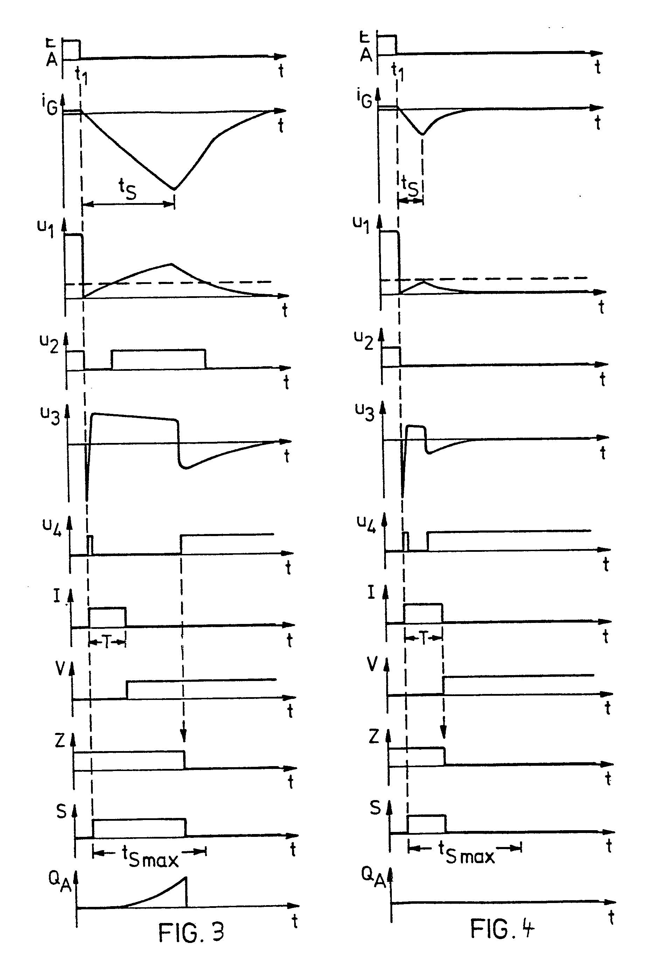

Die Funktionsweise des in Figur 2 dargestellten Ausführungsbeispiels der erfindungsgemäßen Vorrichtung wird im folgenden anhand der dort bezeichneten Signale und ihrer in Figur 3 und 4 dargestellten zeitlichen Verläufe erörtert.

Die erste steuerbare Schalteinrichtung 204 ist bis zum Zeitpunkt $t_1$ infolge eines Einschaltbefehles E in einem stromleitenden Zustand gesteuert, so daß ein positiver Gate-Strom $i_G$ in den Gate-Anschluß des Abschaltthyristors 200 fließt und dieser sich in einem stromleitenden Schaltzustand befindet. Der die zweite steuerbare Schalteinrichtung 206 bildende Feldeffekttransistor befindet sich in einem stromsperrenden Zustand, so daß an seiner Drain-Source-Strecke D—S eine der Spannungsdifferenz zwischen dem positiven Spannungsanschluß U+ und dem negativen Spannungsanschluß U− entsprechende Spannung abfällt.

Zum Zeitpunkt $t_1$ wird aufgrund eines Abschaltbefehles A die erste steuerbare Schalteinrichtung 204 in einen stromsperrenden und die zweite steuerbare Schalteinrichtung 206 in einen stromleitenden Zustand gesteuert. Das hat zur Folge, daß aus dem negativen Spannungsanschluß U− ein negativer Gate-Strom $i_G$ über den die zweite steuerbare Schalteinrichtung 206 bildenden Feldeffekttransistor in den Gate-Anschluß G des Abschaltthyristors 200 fließt. Im durchgeschalteten Zustand verhält sich der Feldeffekttransistor annähernd wie ein ohmscher Widerstand, so daß an seiner Drain-Source-Strecke D-S eine zu dem negativen Gate-Strom $i_G$ proportionale Spannung abfällt; diese Spannung wird von der Spannungserfassungseinrichtung 212 zur Erzeugung einer entsprechenden Ausgangsgröße $u_1$ erfaßt. Bei dem dargestellten Ausführungsbeispiel ist die Spannungserfassungseinrichtung 212 der Stromerfassungseinrichtung 210 derart an dem Feldeffekttransistor angeschlossen, daß die Ausgangsgröße $u_1$ bei negativen Gate-Strom $i_G$ positiv ist.

Der Schwellenwertkomparator 218 am Ausgang 213 der Stromerfassungseinrichtung 212 vergleicht die Ausgangsgröße $u_1$ mit einem Schwellenwert und erzeugt ein Ausgangssignals $u_2$, das einen positiven Spannungspegel aufweist, wenn der negative Gate-Strom $i_G$ einen negativen Schwellenstromwert unterschreitet, so daß die Ausgangsgröße $u_1$ den Schwellenwert überschreitet. Aus der Ausgangsgröße $u_1$ der Stromerfassungseinrichtung 210 wird weiterhin in dem Differenzierglied 214 ein der zeitlichen Ableitung der Ausgangsgröße $u_1$ entsprechendes Hilfssignal $u_3$ erzeugt. Der nachgeordnete Vorzeichendetektor 216 erfaßt das Vorzeichend es Differenziersignales $u_3$ und erzeugt ein Vorzeichensignal $u_4$, das einen positiven Spannungspegel aufweist, wenn das Vorzeichen des Hilfssignales $u_3$ negativ ist.

Durch den Übergang von dem Einschaltbefehl E zu dem Ausschaltbefehl A zum Zeitpunkt $t_1$ wird die Zeitgeberstufe 221 angesteuert und gibt an ihrem Ausgang 223 ein Impulssignal I mit einer vorgegebenen Zeitdauer T ab. Wenn innerhalb dieser Zeitdauer T der negative Gate-Strom $i_G$ den vorgegebenen negative Schwellenstromwert unterschreitet, wird das Delay-Flipflop 230 gesetzt. Nach einer Speicherzeit $t_s$ von dem Zeitpunkt $t_1$ des Auftretens des Abschaltbefehles A an erreicht der negative Gate-Strom $i_G$ seinen minimalen, negativen Wert und der Abschaltthyristor 200 geht in einen stromsperrenden Schaltzustand über. Dabei zeigt das Vorzeichensignal $u_4$ einen Vorzeichenwechsel der zeitlichen Änderung des negativen Gate-Stromes $i_G$ an und bewirkt so ein Rücksetzen des Delay-Flipflops 230. Durch die logische NAND-Verknüpfung des Ausgangszustandes des Delay-Flipflops 230 an seinem invertierenden Ausgang $\overline{Q}$ mit dem Verzögerungssignal V an dem weiteren Ausgang 224 der Zeitgeberstufe 221 wird ein Zustandssignal Z erzeugt, das nach Beendigung der Speicherzeit $t_s$ durch einen Übergang von einem hohen auf einen niedrigen Spannungspegel den Übergang des Abschaltthyristors 200 in einen stromsperrenden Zustand anzeigt.

Unterschreitet der negative Gate-Strom $i_G$ den vorgegebenen negativen Schwellenstromwert nicht innerhalb der vorgegebenen Zeitdauer T, so kann davon ausgegangen werden, daß sich der Abschaltthyristor 200 im Leerlauf befindet, oder das ein sehr kleiner Durchlaßstrom $i_D$ durch den Abschaltthyristor 200 abgeschaltet wurde und dieser ohne nennenswerten negativen Gate-Strom $i_G$ seinen Sperrzustand erreicht hat. In diesem Fall bleibt das Delay-Flipflop 230 zurückgesetzt und es wird ersatzweise das Zustandssignal Z erzeugt, sobald die vorgegebene Zeitdauer T beendet ist. Dieser Fall ist in Figur 4 dargestellt.

Durch Verknüpfung des Zustandssignales Z mit dem Abschaltbefehl A durch das UND-Glied 234 wird ein Rückmeldesignal S erzeugt, das für die Dauer der Speicherzeit $t_s$ einen positiven Spannungspegel aufweist. Zum Zeitpunkt $t_1$ wird in der Zeitablaufstufe 243 ein Zeitablauf mit einer der maximalen zülassigen Speicherzeit $T_{Smax}$ des Abschaltthyristors 200 entsprechenden Ablaufzeit erzeugt. Wenn die Speicherzeit $t_s$ des Abschaltthyristors 200 kleiner als die vorgegebene Ablaufzeit ist, wird der Zeitablauf in der Zeitablaufstufe 243 nach Beendigung des Rückmeldesignales S unterbrochen. Überschreitet dagegen die Speicherzeit $t_s$ die vorgegebene Ablaufzeit, so wird ein Fehlermeldesignal $F_t$ erzeugt.

Von dem Zeitpunkt an, an dem der negative Gate-Strom $i_G$ den negativen Schwellenstromwert unterschreitet bis zur Beendigung der Speicherzeit $t_s$ des Abschaltthyristors 200 wird das steuerbare Schaltglied 254 der steuerbaren Integriereinrichtung 252 in einen geöffneten Schaltzustand gesteuert; das Integrierglied 253 bildet aus der dem negativen Gate-Strom $i_G$ proportionalen Ausgangsgröße $u_1$ ein weiteres Rückmeldesignal $Q_A$, das dem zeitlichen Integral der Ausgangsgröße $u_1$ entspricht. Nach Ablauf der Speicherzeit $t_s$ entspricht der Wert des Rückmeldesignals $Q_A$ der Abschaltladung des Abschaltthyristors 200 (vgl. Figur 1). Überschreitet der Wert des weiteren Rückmeldesignales $Q_A$ einen der maximalen zulässigen Abschaltladung des Abschaltthyristors 200 entsprechenden Schwellenwert, so wird ein weiteres Fehlermeldesignal $F_Q$ erzeugt.

In Figur 5 ist eine vorteilhafte Anwendungsmöglichkeit der erfindungsgemäßen Vorrichtung bei einem Stromrichter dargestellt. Von dem Stromrichter ist zur Vereinfachung lediglich eine Brückenphase 300 dargestellt, die aus einer ersten Brückenzweighälfte 301 und einer zweiten Brückenzweighälfte 302 besteht. In der ersten Brückenzweighälfte 301 ist ein erster Anschaltthyristor 303 und eine antiparallel erste Freilaufdiode 304 angeordnet; in dem zweiten Brückenzweig 302 liegt ein zweiter Abschaltthyristor 305 mit einer zweiten antiparallelen Freilaufdiode 306. Dem ersten Abschlattthyristor 303 ist eine erste Vorrichtung 307 zugeordnet, wie sie beispielsweise in den Figuren 2, 3 und 6 dargestellt ist. Die erste Vorrichtung 307 enthält einen hier nicht gezeigten Steuergenerator mit einem Steuereingang 308 und einem Steuerausgang 309, der entsprechend der Beaufschlagung des Steuereinganges 308 mit einem Einschaltbefehl E oder einem Abschaltbefehl A den Abschaltthyristor 303 mit einem positiven bzw. einem negativen Gate-Strom $i_G$ ansteuert. Mit 310 ist ein Zustandssignalausgang der Vorrichtung 307 bezeichnet, an dem ein Zustandssignal Z erzeugt wird, wenn sich der erste Abschaltthyristor 303 in einem stromsperrenden Schaltzustand befindet. Dem zweiten Abschaltthyristor 305 ist eine entsprechende zweite Vorrichtung 311 ebenfalls mit einem Steuereingang 312, einem Steuerausgang 313 und einem Zustandssignalausgang 314 zugeordnet. Die Ansteuerung der beiden Abschaltthyristoren 303 und 304 erfolgt über die ihnen zugeordneten Vorrichtungen 307 bzw. 311 in Abhängigkeit von einem Einschaltbefehl E bzw. Abschaltbefehl A. Dabei ist der ersten Vorrichtung 307 ein erstes UND-Glied 315 zugeordnet, das an einem Eingang mit dem Einschaltbefehl E bzw. Abschaltbefehl A beaufschlagt ist und mit einem anderen Eingang an den Zustandssignalausgang 314 der zweiten Vorrichtung 311 angeschlossen ist. Das erste UND-Glied ist ausgangsseitig mit dem Steuereingang 308 der ersten Vorrichtung 307 verbunden. Dem Steuereingang 312 der zweiten Vorrichtung 311 ist ein zweites Und-Glied 316 vorgeschaltet, das ebenfalls an einem Eingang über ein Invertierglied 317 mit dem Einschaltbefehl E bzw. Abschaltbefehl A beaufschlagt ist und mit einem anderen Eingang an dem Zustandssignalausgang 310 der ersten Vorrichtung 307 angeschlossen ist. Auf diese Weise wird eine gegenseitige Verriegelung bei der Ansteuerung der beiden Abschaltthyristoren 303 und 305 erreicht, so daß sich immer nur einer der beiden Abschaltthyristoren 303 und 305 in einem stromleitenden Schaltzustand befindet und ein Kurzschluß innerhalb der Brückenphase ausgeschlossen ist. Eine derartige Verriegelung läßt sich bei den weiteren nicht dargestellten Brückenphasen des Stromrichters auf die gleiche Weise erreichen.

## Patentansprüche

1. Verfahren zur Bestimmung des Schaltzustandes eines Abschaltthyristors (GTO-Thyristor), der in Abhängigkeit von einem Einschalt- bzw. Abschaltsignal in einen stromleitenden bzw. einen stromsperrenden Schaltzustand steuerbar ist, dadurch gekennzeichnet, daß der in den Gate-Anschluß des Abschaltthyristors fließende Gate-Strom erfaßt wird, daß nach dem Auftreten eines Abschaltsignales ein Hilfssignal gebildet wird, welches der zeitlichen Änderung des Gate-Stromes entspricht, und daß bei einem Vorzeichenwechsel des Hilfssignales ein Zustandssignal erzeugt wird, welches den Übergang des Abschaltthyristors in den stromsperrenden Schaltzustand anzeigt.

2. Verfahren nach Anspruch 1, dadurch gekennzeichnet, daß der erfaßte Gate-Strom auf Unterschreiten eines negativen Schwellenstromwertes überwacht wird und ein den Übergang des Abschaltthyristors in den stromsperrenden Schaltzustand anzeigendes Zustandssignal erst erzeugt wird, wenn auch der negative Schwellenstromwert unterschritten ist.

3. Verfahren nach Anspruch 2, dadurch gekennzeichnet, daß ein den stromsperrenden Schaltzustand anzeigendes Zustandssignal auch dann erzeugt wird, wenn innerhalb einer vorgegebenen Zeitdauer nach dem Auftreten des Abschaltsignales der negative Schwellenstromwert nicht unterschritten worden ist.

4. Verfahren nach einem der vorangehenden Ansprüche, dadurch gekennzeichnet, daß gleichzeitig mit dem Auftreten des Abschaltsignales ein Zeitablauf mit einer vorgegebenen Ablaufzeit veranlaßt und ein Fehlermeldesignal erzeugt wird, wenn der Zeitablauf vor dem Auftreten des Zustandssignales beendet ist.

5. Verfahren nach Anspruch 4, dadurch gekennzeichnet, daß beim Auftreten des Fehlermeldesignales der Abschaltthyristor in einen stromleitenden Zustand gesteuert wird.

6. Verfahren nach einem der Ansprüche 1 bis 5, dadurch gekennzeichnet, daß vom Auftreten des Abschaltsignales an bis zur Erzeugung des Zustandssignales aus dem erfaßten Gate-Strom eine Integrationsgröße abgeleitet wird, die dem zeitlichen Integral des Gate-Stromes entspricht und daß ein Überlastungsmeldesignal erzeugt wird, wenn die integrationsgröße vor dem Auftreten des Zustandsignales einen vorgegebenen Schwellenwert überschreitet.

7. Verfahren nach Anspruch 6, dadurch gekennzeichnet, daß beim Auftreten des Überlastungsmeldesignales der Abschaltthyristor in einen stromleitenden Zustand gesteuert wird.

8. Anwendung des Verfahrens nach einem der vorangehenden Ansprüche bei jedem von zwei Abschaltthyristoren, von denen der erste Abschaltthyristor in einer Brückenzweighälfte und der zweite Abschaltthyristor in der anderen Brückenzweighälfte eines Stromrichters liegt, dadurch gekennzeichnet, daß das Einschaltsignal dem ersten Abschaltthyristor nur beim Vorhandensein des den stromsperrenden Schaltzustand des zweiten Abschaltthyristors anzeigenden Zustandssignales zugeführt wird und daß das Einschaltsignal dem zweiten Abschaltthyristor nur beim Vorhandensein des den stromsperrenden Schaltzustand des ersten Abschaltthyristors anzeigenden Zustandssignales zugeführt wird.

9. Vorrichtung zur Bestimmung des Schaltzustandes eines Abschaltthyristors (GTO-Thyristor), der mit seinem Gate-Anschluß und seinem Kathodenanschluß an einem Abschaltstromkreis angeschlossen ist, dadurch gekennzeichnet, daß eine Stromerfassungseinrichtung (210) mit ihrem strompfindlichen Eingang (211) in dem Abschaltstromkreis (207) angeordnet ist, daß an dem Ausgang (213) der Stromerfassungseinrichtung (210) ein Differenzglied (214) angeschlossen ist und daß dem Differenzierglied (214) ein Vorzeichendetektor (216) nachgeordnet ist, dessen Ausgang (217) zur Abgabe eines Zustandssignales mit einem Zustandssignalausgang (229) der Vorrichtung in Verbindung steht.

10. Vorrichtung nach Anspruch 9, wobei in dem Abschaltstromkreis eine steuerbare Schalteinrichtung angeordnet ist, dadurch gekennzeichnet, daß die steuerbare Schalteinrichtung (206) ein Feldeffekttransistor ist, daß der Drain-Anschluß (D) und der Source-Anschluß (S) des Feldeffekttransistors den strompfindlichen Eingang (211) der Stromerfassungseinrichtung (210) bilden, an dem eine Spannungserfassungseinrichtung (213) zur Erfassung des Spannungsabfalls an dem Feldeffekttransistor liegt.

11. Vorrichtung nach Anspruch 9 oder 10, gekennzeichnet durch einen Schwellenwertkomparator (218), der an dem Ausgang (213) der Stromerfassungseinrichtung (210) liegt, eine Zeitgeberstufe (221), die bei Beaufschlagung mit dem Abschaltsignal (A) an einem Ausgang (223) ein Impulssignal (I) mit einer vorgegebenen Zeitdauer (T) abgibt, und eine steuerbare Speichereinrichtung (226), die mit einem ersten Steuereingang (225) an dem Ausgang (223) der Zeitgeberstufe (221) angeschlossen ist, mit einem zweiten Steuereingang (227) an dem Ausgang (219) des Schwellenwertkomparators (218) liegt, über einen dritten Steuereingang (228) an dem Ausgang (217) des Vorzeichendetektors (216) angeschlossen ist und ausgangsseitig mit dem Zustandssignalausgang (229) zur Abgabe des Zustandssignals (Z) in Verbindung steht, wobei die steuerbare Speichereinrichtung (226) während der Ansteuerung ihres ersten Steuereingangs (225) durch Ansteuerung des zweiten Steuereingangs (227) von einem ersten Zustand, in dem die steuerbare Speichereinrichtung (226) bei Beendigung der Ansteuerung ihres ersten Steuereingangs (225) das Zustandssignal (Z) abgibt, in einen zweiten Zustand umsteuerbar ish, in dem die steuerbare Speichereinrichtung (226) bei Ansteuerung des dritten Steuereingangs (228) ein Zustandssignal (Z) abgibt.

12. Vorrichtung nach Anspruch 11, dadurch gekennzeichnet, daß die steuerbare Speichereinrichtung (226) ein Delay-Flipflop (230) enthält,

9

dessen Dateneingang (D) den ersten Steuereingang (225) bildet, dessen Takteingang den zweiten Steuereingang (227) bildet und dessen Rücksetzeingang (R) der dritte Steuereingang (228) ist, daß die Zeitgeberstufe (221) bei Beaufschlagung mit dem Anschaltsignal (A) an einem weiteren Ausgang (224) ein Verzögerungssignal (V) mit einer der vorgegebenen Zeitdauer (T) entsprechenden Verzögerung abgibt und daß der weitere Ausgang (224) der Zeitgeberstufe (221) und der invertierende Ausgang (Q̄) des Delay-Flipflops (230) über ein UND-Glied (231) mit dem Zustandssignalausgang (229) verbunden sind.

13. Vorrichtung nach einem der Ansprüche 9 bis 12, dadurch gekennzeichnet, daß an dem Ausgang (213) der Stromerfassungseinrichtung (210) eine Integriereinrichtung (252) liegt, die einen Unterbrechungseingang (255) aufweist, der mit dem Zustandssignalausgang (229) in Verbindung steht und daß der Integriereinrichtung (252) ein Schwellenwertdetektor (257) nachgeschaltet ist, der ausgangsseitig zur Abgabe eines Überlastungsmeldesignales (F_Q) mit einem Überlastungsmeldeausgang (260) der Vorrichtung in Verbindung steht.

14. Vorrichtung nach einem der Ansprüche 9 bis 13, gekennzeichnet durch eine Zeitablaufvorrichtung (243) zur Erzeugung eines Zeitablaufes mit einem Starteingang (244), der mit dem Abschaltsignal (A) beaufschlagt ist, mit einem Unterbrechungseingang (245), der mit dem Zustandssignalausgang (237) in Verbindung steht und mit einem Fehlermeldeausgang (246) zur Abgabe eines Fehlermeldesignales (F_t) bei Beendigung des Zeitablaufes.

15. Vorrichtung nach Anspruch 14, dadurch gekennzeichnet, daß die Zeitablaufvorrichtung (243) ein Monoflop (247) enthält, dessen Triggereingang (248) den Starteingang (244) der Zeitablaufvorrichtung (243) bildet, daß der Ausgang (249) des Monoflops (247) mit dem Takteingang eines Delay-Flipflops (250) verbunden ist, dessen Dateneingang (D) den Unterbrechungseingang (245) bildet und dessen Ausgang (Q) den Fehlermeldeausgang (246) der Zeitablaufvorrichtung (243) bildet.

16. Vorrichtung nach einem der Ansprüche 14 und 15, wobei der Abschaltthyristor mit seinem Gate-Anschluß und seinem Kathodenanschluß in einem Einschaltstromkreis angeordnet ist, dadurch gekennzeichnet, daß der Gate-Anschluß (G) über eine zusätzliche steuerbare Schalteinrichtung an einem positiven Hilfsspannungsanschluß angeschlossen ist und daß der Steuereingang der zusätzlichen steuerbaren Schalteinrichtung mit dem Fehlermeldeausgang verbunden ist.

17. Vorrichtung nach Anspruch 13 und 16, dadurch gekennzeichnet, daß der Überlastungsmeldeausgang mit dem Steuereingang der zusätzlichen steuerbaren Schalteinrichtung in Verbindung steht.

**Revendications**

1. Procédé pour déterminer l'état de commutation d'un thyristor blocable (thyristor GTO), qui peut être commandé en fonction d'un signal de mise à l'état passant ou de blocage dans un état de commutation conduisant le courant ou bloquant le courant, caractérisé par le fait que le courant de grille, qui pénètre dans la borne de grille du thyristor commutable, est détecté, qu'après l'apparition d'un signal de blocage, un signal auxiliaire, qui correspond à la variation dans le temps du courant de grille, est formé, et que, lors d'un changement de signe du signal auxiliaire, un signal d'état est produit, qui indique le passage du thyristor blocable à l'état de commutation bloquant le courant.

2. Procédé suivant la revendication 1, caractérisé par le fait que l'on contrôle le passage du courant de grille détecté au-dessous d'une valeur négative du courant de seuil et qu'un signal d'état indiquant le passage du thyristor blocable dans l'état de commutation bloquant le courant n'est produit que s'il y a également passage au-dessous de la valeur de seuil négative.

3. Procédé suivant la revendication 2, caractérisé par le fait qu'un signal d'état indiquant l'état de commutation bloquant le courant est également produit lorsqu'au cours d'un intervalle de temps prédéterminé après l'apparition du signal de blocage, il n'y a pas passage au-dessous de la valeur de seuil négative.

4. Procédé suivant l'une des revendications précédentes, caractérisé par le fait que simultanément avec l'apparition du signal de blocage, un cycle temporel possédant une durée prédéterminée est déclenché et un signal de signalisation de défaut est produit lorsque le cycle temporel se termine avant l'apparition du signal d'état.

5. Procédé suivant la revendication 4, caractérisé par le fait que lors de l'apparition du signal de signalisation de défaut, le thyristor de blocage est commandé dans un état de conduction du courant.

6. Procédé suivant l'une des revendications 1 à 5, caractérisé par le fait qu'à partir de l'apparition du signal de blocage et jusqu'à la production du signal d'état, une grandeur d'intégration, qui correspond à l'intégrale dans le temps du courant de grille, est dérivée du courant de grille détecté, et qu'un signal de signalisation de surcharge est produit lorsque la grandeur d'intégration dépasse une valeur de seuil prédéterminée, avant l'apparition du signal d'état.

7. Procédé suivant la revendication 6, caractérisé par le fait que lors de l'apparition du signal de signalisation de surcharge, le thyristor blocable est commandé dans un état de conduction du courant.

8. Application du procédé suivant l'une des revendications précédentes, pour chacun de deux thyristors blocables, dont le premier est situé dans une moitié d'une branche et dont le second est situé dans l'autre moitié d'une branche du point d'un convertisseur statique, caractérisée par le fait que le signal de mise à l'état passant est envoyé au premier thyristor blocable uniquement lors de la présence du signal d'état indiquant l'état de commutation, bloquant le courant, du second thyristor blocable, et que le signal de mise à l'état passant est envoyé au second thyristor blocable uniquement dans le cas de la présence du signal d'état indiquant l'état de commutation, bloquant le courant, du premier thyristor blocable.

9. Dispositif pour déterminer l'état de commutation d'un thyristor blocable (thyristor GTO), dont la borne de grille et la borne de cathode sont raccordées à un circuit de débranchement de blocage, caractérisé par le fait qu'un dispositif (210) de détection du courant, comportant une entrée (211) sensible au courant, est branché dans le circuit de blocage (207), qu'un circuit différentiateur (214) est raccordé à la sortie (213) du dispositif (210) de détection du courant, et qu'en aval du circuit différentiateur (214) est branché un détecteur de signe (216), dont la sortie (217) est reliée à une sortie (229) du signal d'état du dispositif, pour la délivrance d'un signal d'état.

10. Dispositif suivant la revendication 9, dans lequel un dispositif de commutation commandable est branché dans le circuit de blocage, caractérisé par le fait que le dispositif de commutation commandable (206) est un transistor à effet de champ, que la borne de drain (D) et la borne de source (S) du transistor à effet de champ forment l'entrée (211) du dispositif (210) de détection du courant, qui est sensible au courant et à laquelle est raccordé un dispositif (213) de détection de la tension, qui sert à détecter la chute de tension au niveau du transistor à effet de champ.

11. Dispositif suivant la revendication 9 ou 10, caractérisé par un comparateur à valeur de seuil (218), qui est raccordé à la sortie (213) du dispositif (210) de détection du courant, un étage formant minuterie (221) qui, lorsqu'il est chargé par un signal de blocage (A), délivre sur une sortie (223) un signal impulsionnel (I) possédant une durée prédéterminée (T), et un dispositif de mémoire commandable (226), qui est raccordé par une première entrée de commande (225) à la sortie (223) de l'étage formant minuterie (221), par une seconde entrée de commande (227) à la sortie (219) du comparateur à valeur de seuil (218) et par une troisième entrée de commande (228) à la sortie (217) du détecteur de signe (216) et est reliée, côté sortie, à la sortie (229) du signal d'état, pour la délivrance du signal d'état (Z), le dispositif de mémoire commandable (226) pouvant être commuté, pendant l'attaque de sa première entrée de commande (225), au moyen de l'attaque de la seconde entrée de commande (227), depuis un premier état, dans lequel le dispositif de mémoire commandable (226) délivre le signal d'état (Z) à la fin de l'attaque de sa première entrée de commande (225), dans un second état, dans lequel le dispositif de mémoire commandable (226) délivre un signal d'état (Z) lors de l'attaque de la troisième entrée de commande (228).

12. Dispositif suivant la revendication 11, caractérisé par le fait que le dispositif de mémoire commandable (226) comporte une bascule bistable de retardement (230), dont l'entrée de données (D) forme la première entrée de commande (225), dont l'entrée de cadence forme la seconde entrée de commande (227) et dont l'entrée de remise à l'état initial (R) forme la troisième entrée de commande (228), que, lorsqu'il est chargé par le signal de blocage (A) au niveau d'une autre sortie (224), l'étage formant minuterie (221) délivre un signal retardé (V) présentant un retard correspondant à la durée prédéterminée (T), et que l'autre sortie (224) de l'étage formant minuterie (221) et la sortie inverseuse ($\bar{Q}$) de la bascule bistable de retardement (230) sont reliées par l'intermédiaire d'un circuit ET (231) à la sortie (229) délivrant le signal d'état.

13. Dispositif suivant l'une des revendications 9 à 12, caractérisé par le fait qu'à la sortie (213) du dispositif (210) de détection du courant est branché un dispositif intégrateur (252), qui comporte une entrée d'interruption (255) relié à la sortie (229) délivrant le signal d'état, et qu'en aval du circuit intégrateur (252) est branché un détecteur de valeurs seuil (257), dont le côté sortie est raccordé à une sortie (260) de signalisation d'une surcharge du dispositif, pour la délivrance d'un signal de signalisation de surcharge ($F_Q$).

14. Dispositif suivant l'une des revendications 9 à 13, caractérisé par un dispositif de production de cycles temporels (242) servant à produire un cycle temporel et comportant une entrée de démarrage (244) chargée par un signal de blockage (A), une entrée d'interruption (245) reliée à la sortie (237) du signal d'état, et une sortie (246) de signalisation de défaut (246) servant à délivrer un signal de signalisation de défaut ($F_t$) à la fin du cycle temporel.

15. Dispositif suivant la revendication 14, caractérisé par le fait que le dispositif de production de cycles temporels (243) contient une bascule monostable (247), dont l'entrée de déclenchement (248) forme l'entrée de démarrage (244) du dispositif de production de cycles temporels (243), que la sortie (249) de la bascule monostable (247) est reliée à l'entrée de cadence d'une bascule bistable de retardement (250), dont l'entrée de données (D) forme l'entrée d'interruption (245) et dont la sortie (Q) forme la sortie de signalisation de défaut (246) du dispositif de production de cycles temporels (243).

16. Dispositif suivant l'une des revendications 14 et 15, sans lequel le thyristor blocable est branché, au moyen de sa borne de grille et de sa borne de cathode, dans un circuit de mise à l'état passant, caractérisé par le fait que la borne de grille (G) est raccordée par l'intermédiaire d'un dispositif de commutation supplémentaire commandable à une borne à tension alternative positive et que l'entrée de commande du dispositif de commutation supplémentaire commandable est reliée à la sortie de signalisation de défaut.

17. Dispositif suivant les revendications 13 et 16, caractérisé par le fait que la sortie de signalisation de surcharge est reliée à l'entrée de commande du dispositif de commutation supplémentaire commandable.

## Claims

1. Method for determining the circuit state of a turnoff-thyristor (GTO-thyristor) which can be set to a current-conducting or a current-blocking state, in dependence upon a turn-on or turn-off signal, characterised in that the gate current flowing into the turn-off thyristor is detected, and in that, after the occurrence of a turn-off signal, an auxiliary signal is formed which corresponds to the time change in the gate current, and in that, when there is a change of polarity in the auxiliary signal, a status signal is generated which indicates the transition of the turn-off thyristor to the current-blocking state.

2. Method according to claim 1, characterised in that the gate current which is detected is monitored to check when it falls below a negative threshold current value, and a status signal indicating the transition of the turn-off thyristor to the current-blocking circuit state is not generated until the gate current detected also falls below the negative threshold current value.

3. Method according to claim 2, characterised in that a status signal indicating the current-blocking circuit state is also generated if, within a preselected time after the occurrence of the turn-off signal, the gate current detected has not fallen below the negative threshold current value.

4. Method according to one of the preceding claims, characterised in that, simultaneously with the occurrence of the turn-off signal, a time operation with a pre-selected operating time is produced and a fault signal is generated, if the time operation is completed before the occurrence of the status signal.

5. Method according to claim 4, characterised in that, when the fault signal occurs, the turn-off thyristor is set to a current-conducting state.

6. Method according to one of claims 1 to 5, characterised in that, from the occurrence of the turn-off signal until the generation of the status signal, an integration value is derived from the detected gate current, which integration value corresponds to the time integral of the gate current, and in that an overload signal is generated when the integration value exceeds a pre-selected threshold value before the occurrence of the status signal.

7. Method according to claim 6, characterised in that, when the overload signal occurs, the turn-off thyristor is set to a current-conducting state.

8. Application of the method according to one of the preceding claims, with each of two turn-off thyristors, the first of which lies in one half of a bridge arm of a static converter, and the second of which lies in the other half of a bridge arm of the said static converter, characterised in that the turn-on signal is supplied to the first turn-off thyristor only in the presence of the status signal indicating the current-blocking circuit state of the second turn-off thyristor, and in that the turn-on signal is supplied to the second turn-off thyristor only in the presence of the status signal indicating the current-blocking circuit state of the first thyristor.

9. Apparatus for determining the circuit state of a turn-off thyristor (GTO-thyristor) which is connected by its gate terminal and its cathode terminal to a turn-off circuit, characterised in that a current-detection device (210), with its current-sensitive input (211), is arranged in the turn-off circuit (207), and in that a differentiating element (214) is connected to the output (213) of the current-detection device (210), and in that a polarity sign detector (216) is arranged after the differentiating element (214), the output (217) of which polarity sign detector (216) is connected to a status signal output (229) of the apparatus, for delivering a status signal.

10. Apparatus according to claim 9, with a controllable switching device arranged in the turn-off circuit, characterised in that the controllable switching device (206) is a field effect transistor, and in that the drain terminal (D) and the source terminal (S) of the field effect transistor form the current-sensitive input (211) of the current-detection device (210), to which current-sensitive input (211) a voltage-detection device (213) for detecting the voltage drop is connected, across the field effect transistor.

10. Apparatus according to claim 9, with a controllable switching device arranged in the turn-off circuit, characterised in that the controllable switching device (206) is a field effect transistor, and in that the drain terminal (D) and the source terminal (S) of the field effect transistor form the current-sensitive input (211) of the current-detection device (210), to which current-sensitive input (211) a voltage-detection device (213) for detecting the voltage drop is connected, across the field effect transistor.

11. Apparatus according to claim 9 or 10, characterised by a threshold value comparator (218) which is connected across the output (213) of the current-detection device (210), a timer step (221) which, when the turn-off signal (A) is applied to an output (223), delivers an impulse signal (I) with a pre-selected time (T), and a controllable memory device (226) which is connected by a first control input (225) to the output (223) of the timer step (221), and which is connected by a second control input (227) across the output (219) of the threshold value comparator (218), and which is connected by way of a third control input (228) to the output (217) of the polarity sign detector (216) and is connected on the output side to the status signal output (229), for delivering the status signal (Z), the controllable memory device (226) being capable of being reversed, during the triggering of its first control input (225) by the triggering of the second control input (227), from a first state, in which the controllable memory device (226) delivers the status signal (Z) when the triggering of its first control input (225) is complete, and set to a second state, in which the controllable memory device (226) delivers a status signal (Z) when the third control input (228) is triggered.

12. Apparatus according to claim 11, characterised in that the controllable memory device (226) comprises a delay flip-flop (230), the data input (D) of which forms the first control input (225), the clock input of which forms the second control input (227) and the resetting input (R) of which is the third control input (228), and in that the timer step (221) delivers, when a turn-off signal (A) is applied to a further output (224), a delay signal (V) with a delay corresponding to the pre-selected time (T), and in that the further output (224) of the timer step (221) and of the inverting output ($\overline{Q}$) of the delay flip-flop (230) are connected by way of an AND element (231) to the status signal output (229).

13. Apparatus according to one of claims 9 to 12, characterised in that, across the output (213) of the current-detection device (210), is connected an integrating device (252) which has an interrupt input (255) connected to the status signal output (229), and in that a threshold detector (257) is connected after the integrating device (252), which threshold detector (257) is connected on the output side to an overload signal output (260) of the apparatus, for delivering an overload signal ($F_Q$).

14. Apparatus according to one of claims 9 to 13, characterised by time operation apparatus (243) for generating a time operation, with a start input (244) to which the turn-off signal (A) is applied, with an interrupt input (245) which is connected to the status signal output (237), and with a fault signal output (246) for delivering a fault signal ($F_t$) when the time operation is complete.

15. Apparatus according to claim 14, characterised in that the time operation apparatus (243) comprises a monostable flip-flop (247), the trigger input (248) of which forms the start input (244) of the time operation apparatus (243), and in that the output (249) of the monostable flip-flop (247) is connected to the clock input of a delay flip-flop (250), the data input (D) of which forms the interrupt input (245), and the output (Q) of which forms the fault signal output (246) of the time operation apparatus (243).

16. Apparatus according to one of claims 14 and 15, the turn-off thyristor with its gate terminal and its cathode terminal being arranged in a turn-on circuit, characterised in that the gate terminal (G) is connected by way of an additional, controllable switching device to a positive auxiliary voltage terminal, and in that the control input of the additional, controllable switching device is connected to the fault signal output.

17. Apparatus according to claim 13 and 16, characterised in that the overload signal output is connected to the control input of the additional, controllable switching device.

FIG. 1

FIG. 5

FIG. 2

FIG. 3

FIG. 4